(19) Europäisches Patentamt
European Patent Office
Office européen des brevets

(11) **EP 3 343 550 A1**

(12) **EUROPEAN PATENT APPLICATION**
published in accordance with Art. 153(4) EPC

(43) Date of publication:
**04.07.2018 Bulletin 2018/27**

(51) Int Cl.:
*G09G 3/32* (2016.01)  *G09G 3/20* (2006.01)
*G09G 3/34* (2006.01)  *H01L 33/00* (2010.01)
*H05B 37/02* (2006.01)

(21) Application number: **16839056.5**

(22) Date of filing: **05.08.2016**

(86) International application number:
**PCT/JP2016/073131**

(87) International publication number:
**WO 2017/033709 (02.03.2017 Gazette 2017/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **24.08.2015 JP 2015164376**

(71) Applicant: **Mitsubishi Electric Corporation
Chiyoda-ku
Tokyo 100-8310 (JP)**

(72) Inventors:
• **MATOBA, Takashi
Tokyo 100-8310 (JP)**
• **SHIBUE, Shigenori
Tokyo 100-8310 (JP)**
• **ASAMURA, Yoshinori
Tokyo 100-8310 (JP)**

(74) Representative: **Pfenning, Meinig & Partner mbB
Patent- und Rechtsanwälte
Theresienhöhe 11a
80339 München (DE)**

(54) **LED DISPLAY DEVICE AND METHOD FOR CORRECTING LUMINANCE THEREOF**

(57) It is an object of the present invention to provide an LED display device which performs luminance correction of each LED element by reducing the amount of computation required for calculation of a lighting time of the LED element and the amount of data to be stored, and a luminance correction method therefor. An LED display device (100) includes a first display unit (10) including a plurality of LED elements, a second display unit (20) including a measurement LED element equivalent to the LED element included in the first display unit (10), a luminance measurement unit (9) to measure a luminance of the measurement LED element, a luminance decrease rate storage unit (11) to store therein a luminance decrease rate of the measurement LED element, an accumulated lighting time estimation unit (6) to estimate an accumulated lighting time at intervals of a predetermined time, an average duty ratio storage unit (7) to store therein an average duty ratio obtained by dividing the accumulated lighting time which is estimated, by an accumulated operating time, and a luminance correction coefficient calculation unit (12) to obtain a luminance decrease rate with reference to the luminance decrease rate storage unit (11) and the average duty ratio storage unit (7) and calculate a luminance correction coefficient from the luminance decrease rate.

FIG. 1

**EP 3 343 550 A1**

**Description**

Technical Field

The present invention relates to an LED display device and a luminance correction method therefor, and more particularly to an LED display device which displays thereon video information by blinking control of a plurality of LEDs (Light Emitting Diodes) arranged in matrix.

Background Art

Display devices using LEDs are widely used for outdoor and indoor advertising displays and the like by virtue of technology development of LEDs and reduced cost. These LED display devices are mainly used for displaying moving images of natural images and animations so far. In recent years, since the range of visibility is shortened with the narrowed pixel pitch, the LED display devices are used for conference rooms, monitoring uses, and the like. For monitoring uses, particularly, the LED display devices display PC images close to still images in more cases. As to the LEDs, however, since the luminance decreases as the lighting time becomes longer, the LEDs have varied luminance decrease rates depending on image contents and consequently there arise variations in luminance and color among pixels.
For reducing the above-described variations in luminance and color, well known is a method of detecting the luminance of a display unit of the LED and correcting luminance data. Further, also known is another method of accumulating the lighting time of the LED and correcting the luminance on the basis of a luminance correction coefficient which is already measured in accordance with the accumulated time (for example, see Patent Documents 1 and 2).

Prior Art Documents

Patent Documents

Patent Document 1: Japanese Patent Application Laid-Open No. 11-15437
Patent Document 2: Japanese Patent Application Laid-Open No. 2006-330158

Summary

Problem to be Solved by the Invention

For reducing the variations in luminance and color caused by the difference in the lighting time among the LEDs, there is a method of accumulating the lighting time for each of LED elements and correcting the luminance in accordance with the accumulated lighting time. Since the number of used LED elements has increased as the pixel pitch has become narrower, however, a huge amount of lighting time accumulation processing is needed in order to accumulate the lighting time of each of the LED elements. Therefore, there arises a problem of increasing the time required for the processing. Further, there arises another problem of increasing the amount of data required to store the lighting time of each of the LED elements.
The present invention is intended to solve the above problems, and it is an object of the present invention to provide an LED display device which performs luminance correction of each LED element by reducing the amount of computation required for calculation of a lighting time of the LED element and the amount of data to be stored, and a luminance correction method therefor.

Means to Solve the Problem

The present invention is intended for an LED display device. According to an aspect of the present invention, the LED display device includes a first display which includes a plurality of LED elements, a first driver to drive the plurality of LED elements of the first display on the basis of a video signal received from a video signal processor, a second display which includes at least one measurement LED element equivalent to one of the plurality of LED elements included in the first display, a second driver to drive the measurement LED element of the second display, a luminance measurer to measure a luminance of the measurement LED element, a luminance decrease rate storage to store therein a relation between a lighting time of the measurement LED element and a luminance decrease rate of the measurement LED element based on a measurement result of the luminance measurer, an accumulated lighting time estimator to estimate an accumulated lighting time at intervals of a predetermined time for each of the plurality of LED elements, an average duty ratio storage to store therein an average duty ratio obtained by dividing the accumulated lighting time which is estimated, by an accumulated operating time for the plurality of LED elements, a luminance correction coefficient calculator to obtain a luminance decrease rate with reference to the luminance decrease rate storage and the average duty ratio storage for each of the plurality of LED elements and calculate a luminance correction coefficient from the luminance decrease rate, and a luminance corrector to control the first driver to correct a luminance of each of the plurality of LED elements on the basis of the luminance correction coefficient.

The present invention is also intended for a luminance correction method for an LED display device. According to another aspect of the present invention, in the luminance correction method, the LED display device includes a first display which includes a plurality of LED elements, a first driver to drive the first display on the basis of a video signal received from a video signal processor, a second display which includes at least one measurement LED element equivalent to one of the plurality of LED elements included in the first display, a second driver to drive the second display, a luminance measurer, a luminance decrease rate storage, an accumulated lighting time estimator, an average duty ratio storage, a luminance correction coefficient calculator, and a luminance corrector, and the luminance correction method includes (a) measuring a luminance of the measurement LED element by the luminance measurer, (b) storing a relation between a lighting time of the measurement LED element and a luminance decrease rate of the measurement LED element based on a measurement result of the luminance measurer into the luminance decrease rate storage, (c) estimating an accumulated lighting time at intervals of a predetermined time for each of the plurality of LED elements by the accumulated lighting time estimator, (d) storing an average duty ratio obtained by dividing the accumulated lighting time which is estimated, by an accumulated operating time for the plurality of LED elements into the average duty ratio storage, (e) obtaining a luminance decrease rate with reference to the luminance decrease rate storage and the average duty ratio storage for each of the plurality of LED elements and calculating a luminance correction coefficient from the luminance decrease rate by the luminance correction coefficient calculator, and (f) controlling the first driver to correct a luminance of each of the plurality of LED elements on the basis of the luminance correction coefficient by the luminance corrector.

Effects of the Invention

In the LED display device and the luminance correction method therefor of the present invention, by setting a predetermined time used to estimate the accumulated lighting time to be a time sufficiently longer than a PWM (Pulse Width Modulation) cycle, it is possible to significantly suppress a throughput required for computation, as compared with a case where the accumulated lighting time is calculated for every PMW cycle. Further, since the accumulated lighting time is not calculated for every PMW cycle, it is possible to significantly reduce the amount of computation and the number of storing operations of data into a nonvolatile memory. Therefore, it is possible to reduce the power consumption due to these signal processings.

Furthermore, in the LED display device and the luminance correction method therefor of the present invention, the average duty ratio storage stores therein the average duty ratio calculated on the basis of the accumulated lighting time, instead of the accumulated lighting time. Since the accumulated lighting time increases as the operating time of the LED display device becomes longer, the amount of data for the accumulated lighting time also increases. On the other hand, since the amount of data for the average duty ratio does not increase, it is possible to reduce the amount of data to be stored in the average duty ratio storage.

Further, the LED display device and the luminance correction method therefor of the present invention include the second display and the luminance measurer which measures the luminance of the second display, aside from the first display used as a display screen. It thereby becomes possible to obtain the luminance decrease rate corresponding to the accumulated lighting time of each LED element in the first display with high accuracy, with reference to the luminance decrease rate of the measurement LED element in the second display, without measuring the luminance of the first display. Furthermore, since the luminance correction is performed by using the luminance decrease rate, it is possible to perform the luminance correction with significantly high accuracy. Therefore, even in a case where the LED display device operates for a long time, it is possible to keep the luminance and the white balance in an entire screen of the first display.

These and other objects, features, aspects and advantages of the present invention will become more apparent from the following detailed description of the present invention when taken in conjunction with the accompanying drawings.

Brief Description of Drawings

Fig. 1 is a functional block diagram showing an LED display device in accordance with a first preferred embodiment;
Fig. 2 is a hardware configuration diagram showing the LED display device in accordance with the first preferred embodiment;

Fig. 3 is a view showing a method of driving the LED display device in accordance with the first preferred embodiment;

Fig. 4 is a flowchart showing an operation of an accumulated lighting time estimation unit of the LED display device in accordance with the first preferred embodiment;

Fig. 5 is a graph showing a relation between an accumulated lighting time and a luminance decrease rate of an LED element for green;

Fig. 6 is a graph showing a luminance decrease rate of a measurement LED element, which is stored in a luminance decrease rate storage unit; and

Fig. 7 is a flowchart showing a luminance correction operation of the LED display device in accordance with the first preferred embodiment.

Description of Embodiment(s)

<The First Preferred Embodiment

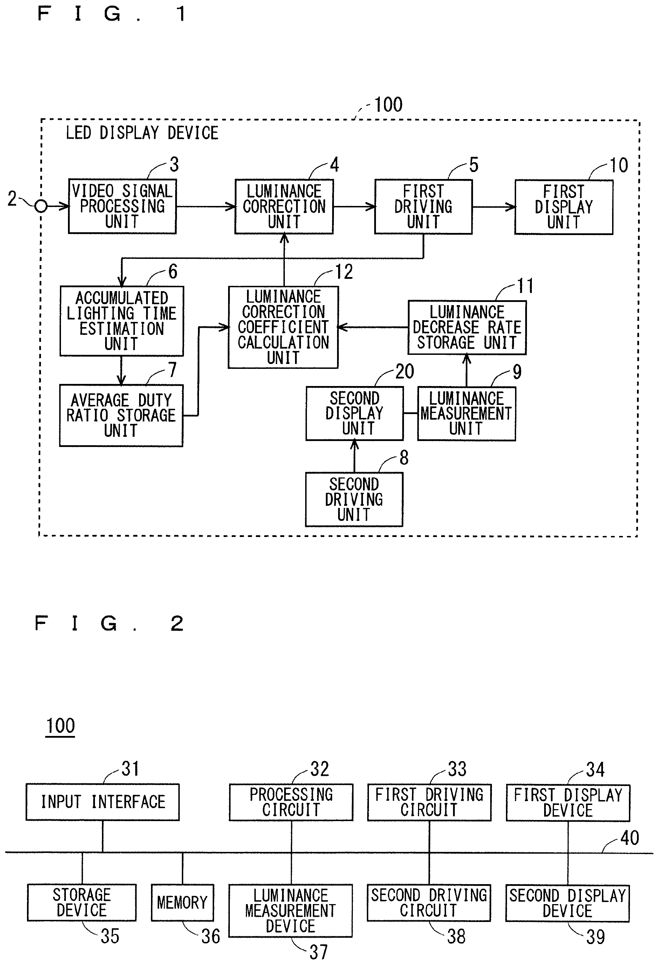

Fig. 1 is a functional block diagram showing an LED display device 100 in accordance with the first preferred embodiment. As shown in Fig. 1, the LED display device 100 includes a first display unit 10, a first driving unit 5, a second display unit 20, a second driving unit 8, a luminance measurement unit 9, a luminance decrease rate storage unit 11, an accumulated lighting time estimation unit 6, an average duty ratio storage unit 7, a luminance correction coefficient calculation unit 12, and a luminance correction unit 4.

The first display unit 10 includes a plurality of unit pixels arranged in a matrix with M rows and N columns. As an exemplary matrix with M rows and N columns, a matrix with 4 rows and 4 columns is used but this is only one exemplary case. In each unit pixel, arranged are three LED elements for red (R), green (G), and blue (B).

The first driving unit 5 drives a plurality of LED elements included in the first display unit 10 on the basis of a video signal received from a video signal processing unit 3. To an input terminal 2 of the video signal processing unit 3, a video signal is inputted from the outside of the LED display device 100. For the video signal inputted from the outside, the video signal processing unit 3 performs a processing to select a region required to display, a gamma correction processing, and the like.

The second display unit 20 includes four unit pixels arranged, for example, in two rows and two columns. In each unit pixel, arranged are luminance measurement LED elements for red, green, and blue each by one. It is assumed herein that the luminance measurement LED elements for red, green, and blue are LED elements equivalent to those for red, green, and blue included in the first display unit 10. Herein, the equivalent LED elements refer to LED elements manufactured with the same specification. Further, it is preferable that the LED element included in the first display unit 10 and the luminance measurement LED element included in the second display unit 20 should be in the same manufacturing lot. The second driving unit 8 drives the luminance measurement LED elements included in the second display unit 20.

The luminance measurement unit 9 measures a luminance of each of the luminance measurement LED elements included in the second display unit 20. The luminance decrease rate storage unit 11 stores therein a time variation in luminance decrease rate of the luminance measurement LED element, which is based on a measurement result of the luminance measurement unit 9.

The accumulated lighting time estimation unit 6 estimates an accumulated lighting time at intervals of a predetermined time for each of the LED elements included in the first display unit 10. The average duty ratio storage unit 7 stores therein an average duty ratio calculated on the basis of the accumulated lighting time estimated by the accumulated lighting time estimation unit 6.

The luminance correction coefficient calculation unit 12 calculates a luminance correction coefficient for each of the LED elements included in the first display unit 10, with reference to the average duty ratio storage unit 7 and the luminance decrease rate storage unit 11. The luminance correction unit 4 controls the first driving unit 5 to correct the luminance of each LED element on the basis of the luminance correction coefficient calculated by the luminance correction coefficient calculation unit 12.

Further, in the present specification, hereinafter, the LED elements included in the first display unit 10 will be referred to simply as LED elements.

Fig. 2 is a hardware configuration diagram showing the LED display device 100. The LED display device 100 includes an input interface 31, a first display device 34, a first driving circuit 33, a second display device 39, a second driving circuit 38, a luminance measurement device 37, a storage device 35, a processing circuit 32, and a memory 36. Further, the above-described constituent elements are connected to one another with a bus 40.

The video signal processing unit 3, the accumulated lighting time estimation unit 6, the luminance correction coefficient calculation unit 12, and the luminance correction unit 4 are implemented by the processing circuit 32. The processing circuit 32 may be dedicated hardware. Further, the processing circuit 32 may be a CPU (Central Processing Unit, also referred to as a processing unit, an arithmetic unit, a microprocessor, a microcomputer, a processor, or a DSP) which executes a program stored in the memory 36.

In a case where the processing circuit 32 is dedicated hardware, the processing circuit 32 corresponds to, for example, a single circuit, a complex circuit, a programmed processor, a parallel-programmed processor, an ASIC (Application Specific Integrated Circuit), an FPGA (Field Programmable Gate Array), or a combination of these circuits or processors. The video signal processing unit 3, the accumulated lighting time estimation unit 6, the luminance correction coefficient calculation unit 12, and the luminance correction unit 4 may be implemented by processing circuits 32 having the individual functions of these constituent elements or by one processing circuit 32 collectively having the respective functions of these constituent elements.

In a case where the processing circuit 32 is a CPU, the respective functions of the video signal processing unit 3, the accumulated lighting time estimation unit 6, the luminance correction coefficient calculation unit 12, and the luminance correction unit 4 are implemented by software, firmware, or a combination of software and firmware. The software and the firmware are each described as a program and stored in the memory 36. The processing circuit 32 reads out the program stored in the memory 36 and executes the program, to thereby implement one of the respective functions of these constituent elements. Further, it can be expressed that these programs cause a computer to perform respective procedures and methods of the video signal processing unit 3, the accumulated lighting time estimation unit 6, the luminance correction coefficient calculation unit 12, and the luminance correction unit 4. Herein, the memory 36 corresponds to, for example, a nonvolatile or volatile semiconductor memory such as a RAM, a ROM, a flash memory, an EPROM, an EEPROM, or the like, a magnetic disk, a flexible disk, an optical disk, a compact disk, a mini disk, a DVD, or the like.

Further, some of the respective functions of the video signal processing unit 3, the accumulated lighting time estimation unit 6, the luminance correction coefficient calculation unit 12, and the luminance correction unit 4 may be implemented by dedicated hardware and the others may be implemented by software or the firmware. Thus, as to the processing circuit, the above-described functions can be implemented by hardware, software, the firmware, or a combination thereof.

The first driving unit 5 is implemented by the first driving circuit 33. The first driving circuit 33 may be dedicated hardware. Further, the first driving circuit 33 may be a CPU which executes a program stored in the memory 36.

In a case where the first driving circuit 33 is dedicated hardware, the first driving circuit 33 corresponds to, for example, a single circuit, a complex circuit, a programmed processor, a parallel-programmed processor, an ASIC, an FPGA, or a combination of these circuits or processors. In a case where the first driving circuit 33 is a CPU, the function of the first driving unit 5 is implemented by software, firmware, or a combination of software and firmware. The software and the firmware are each described as a program and stored in the memory 36. The first driving circuit 33 reads out the program stored in the memory 36 and executes the program, to thereby implement the function of the first driving unit 5.

The second driving unit 8 is implemented by the second driving circuit 38. The second driving circuit 38 may be dedicated hardware. Further, the second driving circuit 38 may be a CPU which executes a program stored in the memory 36.

In a case where the second driving circuit 38 is dedicated hardware, the second driving circuit 38 corresponds to, for example, a single circuit, a complex circuit, a programmed processor, a parallel-programmed processor, an ASIC, an FPGA, or a combination of these circuits or processors. In a case where the second driving circuit 38 is a CPU, the function of the second driving unit 8 is implemented by software, firmware, or a combination of software and firmware. The software and the firmware are each described as a program and stored in the memory 36. The second driving circuit 38 reads out the program stored in the memory 36 and executes the program, to thereby implement the function of the second driving unit 8.

The first display unit 10 is implemented by the first display device 34. The constitution of the first display device 34 corresponds to the above-described constitution of the first display unit 10. The second display unit 20 is implemented by the second display device 39. The constitution of the second display device 39 corresponds to the above-described constitution of the second display unit 20.

The luminance measurement unit 9 is implemented by the luminance measurement device 37. As described later, the luminance measurement device 37 includes photodiodes as many as the number of measurement LED elements.

The average duty ratio storage unit 7 and the luminance decrease rate storage unit 11 are implemented by the storage device 35. The storage device 35 is, for example, a nonvolatile memory. Further, the input terminal 2 of the video signal processing unit 3 is implemented by the input interface 31.

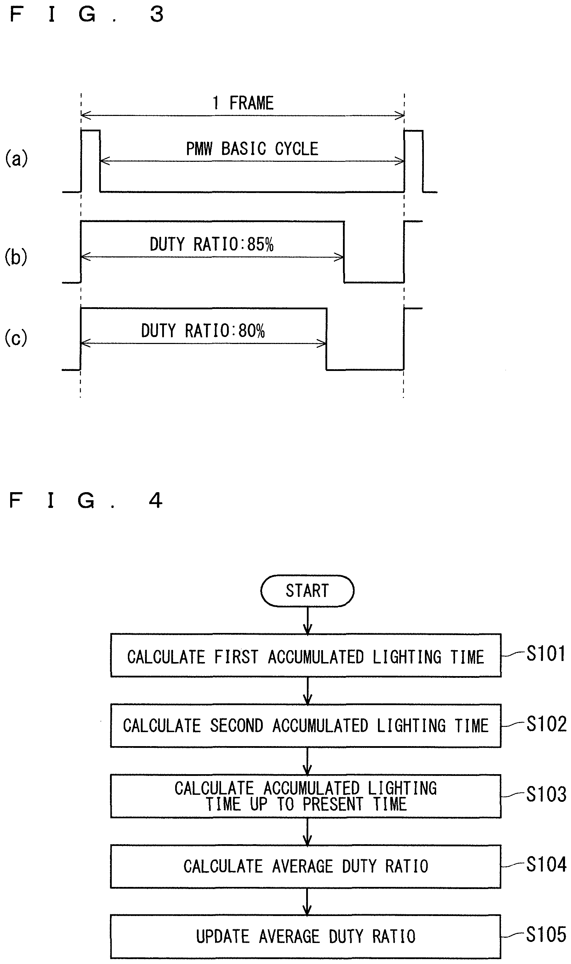

Each of the LED elements included in the first display unit 10 is driven in a PWM (Pulse Width Modulation) mode. Fig. 3 is a view showing an exemplary PWM driving. As shown in Fig. 3(a), each LED element is driven by applying a pulse in synchronization with a cycle of one frame period of the video signal. The pulse width is shorter than one frame period. A ratio of the pulse width to one frame of the video signal is referred to as a duty ratio. Fig. 3(b) shows a case where the LED element is driven with a duty ratio of 85 %. Further, Fig. 3(c) shows a case where the LED element is driven with a duty ratio of 80 %. By driving the LED element with a larger (smaller) duty ratio, the luminance of the LED element can be increased (decreased). The pulse width can be obtained by multiplying a PMW basic cycle by the duty ratio.

An exact accumulated lighting time of each LED element can be obtained by accumulating the pulse width for every one frame. If the pulse width which varies with time is accumulated for every one frame for each of the LED elements, however, a huge amount of computation is needed.

<Operation of Accumulated Lighting Time Estimation Unit>

The accumulated lighting time estimation unit 6 of the first preferred embodiment estimates the accumulated lighting time for each of the LED elements with less amount of computation. Fig. 4 is a flowchart showing an operation of the accumulated lighting time estimation unit 6. The accumulated lighting time estimation unit 6 estimates an accumulated lighting time for each of the plurality of LED elements at intervals of a predetermined accumulated operating time (hereinafter, also referred to as an accumulated unit time) up to the present time. The accumulated unit time is, for example, one minute.

Hereinafter, description will be made on a method of estimating the accumulated lighting time for one of the LED elements (hereinafter, also referred to as an object LED element). When the accumulated unit time elapses after the estimation of the previous accumulated lighting time for the object LED element, the accumulated lighting time estimation unit 6 performs a process of estimating the accumulated lighting time up to the present time for the object LED element.

First, the accumulated lighting time estimation unit 6 calculates a first accumulated lighting time $S_0$ for the object LED element (Step S101). The first accumulated lighting time $S_0$ is a lighting time accumulated up to a time traced back by the accumulated unit time from the present time. The first accumulated lighting time $S_0$ can be obtained by the following Eq. 1.

[Math 1]

$$S_0 = R_0 \times t_0 \quad \cdots (1)$$

Herein, $t_0$ represents an accumulated operating time of the LED display device up to a time traced back by the accumulated unit time from the present time. The operating time is a time period while the LED display device 100 displays thereon an image. Further, $R_0$ represents an average duty ratio of the object LED element. The average duty ratio $R_0$ is an average duty ratio obtained in the calculation of the previous accumulated lighting time and stored into the average duty ratio storage unit 7 for each LED element. Further, when the accumulated lighting time is calculated first, it is assumed, for example, that $R_0 = 0$ since no average duty ratio is stored in the average duty ratio storage unit 7.

Next, the accumulated lighting time estimation unit 6 estimates a second accumulated lighting time $S_1$ for the object LED element (Step S102). The second accumulated lighting time $S_1$ is a lighting time accumulated from the accumulated unit time ago up to the present time. The second accumulated lighting time $S_1$ can be obtained by the following Eq. 2.

[Math 2]

$$S_1 = R_1 \times t_1 \quad \cdots (2)$$

Herein, $t_1$ represents an accumulated operating time of the LED display device from the accumulated unit time ago up to the present time. $R_1$ represents an actual duty ratio with which the object LED element is driven at the present time. In other words, the second accumulated lighting time $S_1$ is calculated on the assumption that the object LED element is driven with the constant duty ratio of $R_1$ from the accumulated unit time ago up to the present time.

Next, the accumulated lighting time estimation unit 6 estimates the accumulated lighting time $S_2$ at the present time for the object LED element (Step S103). As expressed by the following Eq. 3, the accumulated lighting time $S_2$ at the present time is represented by the sum of the first accumulated lighting time $S_0$ and the second accumulated lighting time $S_1$.

[Math 3]

$$S_2 = S_0 + S_1 \quad \cdots (3)$$

Next, the accumulated lighting time estimation unit 6 calculates the average duty ratio $R_2$ at the present time for the object LED element (Step S104). The average duty ratio $R_2$ can be obtained by the following Eq. 4.

[Math 4]

$$R_2 = \frac{S_2}{t_0 + t_1} = \frac{R_0 \times t_0 + R_1 \times t_1}{t_0 + t_1} \qquad \cdots (4)$$

Then, the accumulated lighting time estimation unit 6 updates the old average duty ratio $R_0$ stored in the average duty ratio storage unit 7 by the new average duty ratio $R_2$ (Step S105).

The accumulated lighting time estimation unit 6 performs the above-described process at intervals of a unit time for each of the LED elements. In other words, in the average duty ratio storage unit 7, the average duty ratio for each of the LED elements is updated at intervals of the accumulated unit time.

In a case where there is less time variation of the image displayed on the LED display device, there causes less time variation in the luminance of each LED element. In other words, there is less variation in the duty ratio of each LED element. In such a case, even if the unit time is set to be sufficiently longer than the PMW basic cycle, it is possible to estimate the accumulated lighting time of the LED element with high accuracy.

<Operation Regarding Luminance Measurement Unit>

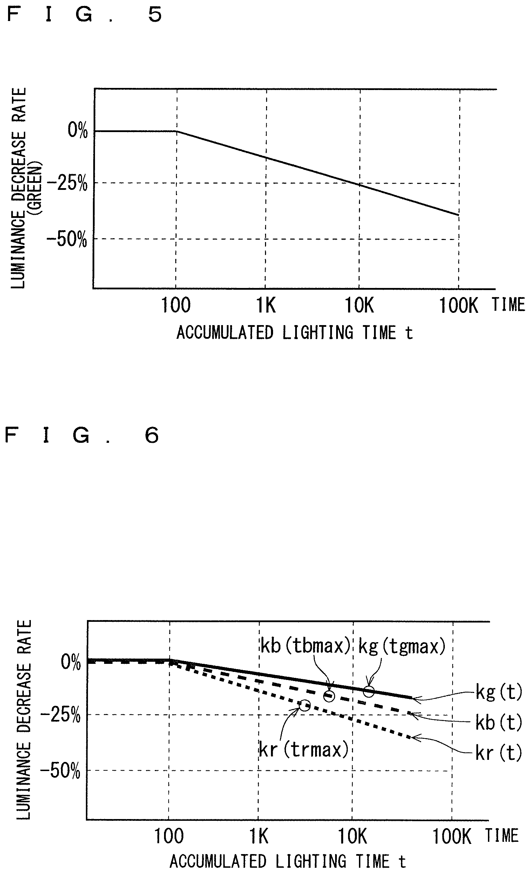

Fig. 5 is a graph showing a relation (luminance decrease rate) between a lighting time and a luminance of the LED element for green. As shown in Fig. 5, the luminance of the LED element decreases with time. Though Fig. 5 shows the luminance decrease rate of the LED element for green as an example, the respective luminances of the LED elements for red and blue also decrease with time.

In the first preferred embodiment, the second display unit 20 dedicated to the measurement of the luminance decrease rate is provided and the luminance of the measurement LED element in the second display unit 20 is measured during a period while the LED display device operates. Hereinafter, description will be made on a method of measuring the luminance decrease rate.

The measurement LED element in the second display unit 20 is always driven by the second driving unit with a duty ratio of 100 %. In other words, the accumulated lighting time of the measurement LED element is necessarily longer than that of one of the LED elements in the first display unit 10, which has the longest accumulated lighting time.

As described earlier, the second display unit 20 includes four unit pixels and in each unit pixel, arranged are three measurement LED elements for red, green, and blue. The measurement LED element is an LED element equivalent to each of the LED elements included in the first display unit 10. By providing a plurality of measurement LED elements for each color and taking an average of measured values of the luminance for each color, it is possible to increase the accuracy of the measured value.

The luminance measurement unit 9 includes a plurality of photodiodes each capable of measuring the wavelength intensity of a visible range. The photodiodes are arranged, facing the measurement LED elements, respectively.

The luminance measurement unit 9 measures the luminance of the measurement LED element for each color on a real time and stores the luminance decrease rate into the luminance decrease rate storage unit 11. As a result, as shown in Fig. 6, the luminance decrease rate storage unit 11 stores therein a relation between the accumulated lighting time and the luminance decrease rate of the measurement LED element for each color up to the present time. In Fig. 6, the luminance decrease rates of the measurement LED elements for red, green, and blue are represented by "kr(t)", "kg(t)", and "kb(t)", respectively, as functions of the accumulated lighting time t.

As described above, by providing the luminance measurement unit 9 and the measurement LED elements equivalent to the LED elements, it becomes possible to measure the luminance decrease rates of the measurement LED elements on a real time.

<Operation Regarding Luminance Correction>

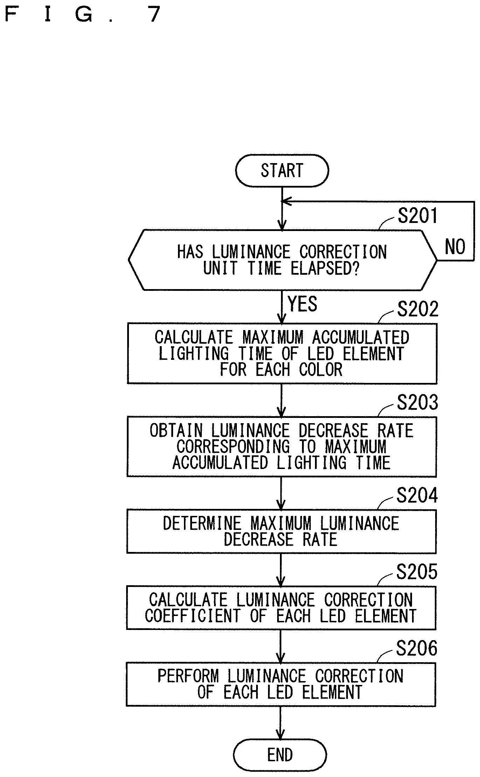

Fig. 7 is a flowchart showing a luminance correction operation of the LED display device 100. The luminance correction operation is performed at intervals of a luminance correction unit time (for example, 100 minutes). First, the luminance correction coefficient calculation unit 12 determines whether or not the luminance correction unit time has elapsed after the calculation of the previous correction coefficient (Step S201).

In a case where a unit operating time has elapsed, the luminance correction coefficient calculation unit 12 calculates maximum accumulated lighting times trmax, tgmax, and tbmax of the LED elements for the three colors (Step S202). First, the luminance correction coefficient calculation unit 12 searches for the largest one among the average duty ratios of all the LED elements for red with reference to the average duty ratio storage unit 7. Then, the maximum accumulated lighting time trmax of the LED element for red is calculated by multiplying the largest average duty ratio by the accumulated operating time up to the present time. Similarly, the luminance correction coefficient calculation unit 12 calculates the maximum accumulated lighting time tgmax of the LED element for green and the maximum accumulated lighting time tbmax of the LED element for blue.

Next, the luminance correction coefficient calculation unit 12 obtains the luminance decrease rates kr(trmax), kg(tgmax), and kb(tbmax) corresponding to the maximum accumulated lighting times of the LED elements for the three colors, respectively (Step S203). First, as shown in Fig. 6, the luminance correction coefficient calculation unit 12 obtains the luminance decrease rate kr(trmax) corresponding to the time trmax with reference to the luminance decrease rate kr(t) of the measurement LED element for red which is stored in the luminance decrease rate storage unit 11. Similarly, the luminance correction coefficient calculation unit 12 obtains the luminance decrease rate kg(tgmax) corresponding to the time tgmax with reference to the luminance decrease rate kg(t) of the measurement LED element for green. The luminance correction coefficient calculation unit 12 obtains the luminance decrease rate kb(tbmax) corresponding to the time tbmax with reference to the luminance decrease rate kb(t) of the measurement LED element for blue.

Next, the luminance correction coefficient calculation unit 12 obtains a maximum luminance decrease rate krgb (Step S204). The luminance correction coefficient calculation unit 12 selects the largest one of the luminance decrease rates kr(trmax), kg(tgmax), and kb(tbmax), as the maximum luminance decrease rate krgb. Specifically, the maximum luminance decrease rate krgb is obtained by the following Eq. 5.

[Math 5]

$$krgb = MAX(kr(trmax), kg(tgmax), kb(tbmax)) \quad \cdots (5)$$

Next, the luminance correction coefficient calculation unit 12 calculates the luminance correction coefficient for each LED element on the basis of the maximum luminance decrease rate krgb (Step S205). The respective corrected luminances Rcomp, Gcomp, and Bcomp of the LED elements for the three colors can be expressed by the following Eq. 6.

[Math 6]

$$
\begin{aligned}
Rcomp &= R_0 \times (1-krgb) = Rp \times hr \\
Gcomp &= G_0 \times (1-krgb) = Gp \times hg \\
Bcomp &= B_0 \times (1-krgb) = Bp \times hb
\end{aligned}
\quad \cdots (6)
$$

Herein, Rp, Gp, and Bp represent the current luminances of the LED elements for the three colors. $R_0$, $G_0$, and $B_0$ represent initial luminances of the LED elements for the three colors, and hr, hg, and hb represent the luminance correction coefficients of the LED elements for the three colors. Further, though the luminance correction coefficients hr, hg, and hb are distinguished from one another by the color, actually, the luminance correction coefficients are not distinguished by the color and are calculated individually for the LED elements. Eq. 6 represents that the luminances of all the LED elements are made equal to one another by correcting the luminances of the LED elements with the luminance correction coefficients (hr, hg, and hb) to meet the maximum luminance decrease rate krgb. Rp, Gp, and Bp can be expressed by the following Eq. 7.

[Math 7]

$$
\begin{aligned}
Rp &= R_0 \times (1-kr(tp)) \\
Gp &= G_0 \times (1-kg(tp)) \\
Bp &= B_0 \times (1-kb(tp))
\end{aligned}
\quad \cdots (7)
$$

Herein, the time tp is the accumulated lighting time up to the present time for each LED element. The accumulated lighting time up to the present time is calculated by multiplying the average duty ratio stored in the average duty ratio storage unit 7 by the accumulated operating time up to the present time.

From Eqs. 6 and 7, the respective luminance correction coefficients hr, hg, and hb of the LED elements for the three colors can be expressed by the following Eq. 8.

[Math 8]

$$\left. \begin{array}{l} hr = \dfrac{1-krgb}{1-kr\,(tp)} \\[2mm] hg = \dfrac{1-krgb}{1-kg\,(tp)} \\[2mm] hb = \dfrac{1-krgb}{1-kb\,(tp)} \end{array} \right\} \cdots (8)$$

Next, the luminance correction unit 4 performs luminance correction of each LED element on the basis of the luminance correction coefficient calculated by the luminance correction coefficient calculation unit 12 (Step S206). Specifically, the luminance correction unit 4 controls the first display unit 10 to correct the duty ratio of each LED element on the basis of the luminance correction coefficient. By correcting the duty ratio of the LED element on the basis of the luminance correction coefficient, the luminance of the LED element can be corrected.

In one LED element for red, for example, when krgb = 0.2 and kr(tp) = 0.1, the luminance correction coefficient hr = (1-0.2)/(1-0.1) = 8/9. Therefore, as to this LED element, a luminance adjustment is performed by driving the LED element with a duty ratio obtained by further multiplying the duty ratio of PWM by 8/9.

In the first preferred embodiment, the luminances of all the LED elements are made equal to one another in accordance with the luminance decrease rate of one of the LED elements included in the first display unit 10, which has the largest luminance decrease rate. It is thereby possible to keep the luminance and the white balance uniform in the entire display screen. Therefore, it is possible to improve the variation in the luminance. Further, the luminance correction mode of the first preferred embodiment has an advantage of adopting a higher initial luminance.

In a case where the average duty ratio storage unit 7 stores therein the accumulated lighting time instead of the average duty ratio, since the accumulated lighting time of the LED element increases in proportion to the accumulated operating time of the first display unit 10, the amount of data increases with time. Therefore, it is necessary to ensure a large memory area.

On the other hand, in the first preferred embodiment, the average duty ratio storage unit 7 stores therein the average duty ratio instead of the accumulated lighting time. Since the amount of data for the average duty ratio does not increase, it is possible reduce the amount of data to be stored in the average duty ratio storage unit 7.

Further, in a case where the accumulated lighting time is calculated and stored for every PMW cycle (i.e., for every one frame), the throughput required for the computation significantly increases. Furthermore, the information on the accumulated lighting time needs to be stored in a nonvolatile memory lest the information is lost when the power supply of the LED display device is turned off. If a cheap serial-control nonvolatile memory is used, it is necessary to write and read the accumulated lighting times of all the LED elements in the LED display device, and this also causes an increase in the access time to the memory.

On the other hand, in the first preferred embodiment, the accumulated lighting time is estimated at intervals of the accumulated unit time sufficiently longer than the PMW cycle. Therefore, it is possible to significantly suppress the throughput required for the computation. Further, since the accumulated lighting time is not calculated for every PMW cycle, it becomes possible to significantly reduce the amount of computation and the number of storing operations of data into the nonvolatile memory. Therefore, it is possible to reduce the power consumption due to these signal processings.

<Effects>

The LED display device 100 of the first preferred embodiment includes the first display unit 10 which includes a plurality of LED elements, the first driving unit 5 to drive the plurality of LED elements of the first display unit 10 on the basis of a video signal received from the video signal processing unit 3, the second display unit 20 which includes at least one measurement LED element equivalent to one of the plurality of LED elements included in the first display unit 10, the second driving unit 8 to drive the measurement LED element of the second display unit 20, the luminance measurement unit 9 to measure a luminance of the measurement LED element, the luminance decrease rate storage unit 11 to store therein a relation between a lighting time of the measurement LED element and a luminance decrease rate of the measurement LED element based on a measurement result of the luminance measurement unit 9, the accumulated lighting time estimation unit 6 to estimate an accumulated lighting time at intervals of a predetermined time for each of the plurality of LED elements, the average duty ratio storage unit 7 to store therein an average duty ratio obtained by dividing the accumulated lighting time which is estimated, by an accumulated operating time for the plurality of LED elements, the luminance correction coefficient calculation unit 12 to obtain a luminance decrease rate with reference to the luminance decrease rate storage unit 11 and the average duty ratio storage unit 7 for each of the plurality of LED elements and calculate a luminance correction coefficient from the luminance decrease rate, and the luminance correction unit 4 to control the first driving unit 5 to correct a luminance of each of the plurality of LED elements on the basis of the luminance correction coefficient.

In the first preferred embodiment, the accumulated lighting time is estimated at intervals of the accumulated operating unit time (i.e., the predetermined time) sufficiently longer than the PMW cycle. Therefore, it is possible to significantly suppress the throughput required for the computation, as compared with the case where the accumulated lighting time is calculated for every PMW cycle. Further, since the accumulated lighting time is not calculated for every PMW cycle, it becomes possible to significantly reduce the amount of computation and the number of storing operations of data into the nonvolatile memory. Therefore, it is possible to reduce the power consumption due to these signal processings.

Further, in the LED display device 100 of the first preferred embodiment, the average duty ratio storage unit 7 stores therein the average duty ratio calculated on the basis of the accumulated lighting time, instead of the accumulated lighting time. Since the accumulated lighting time increases as the operating time of the LED display device 100 becomes longer, the amount of data for the accumulated lighting time also increases. On the other hand, since the amount of data for the average duty ratio does not increase, it is possible reduce the amount of data to be stored in the average duty ratio storage unit 7.

Further, the LED display device 100 of the first preferred embodiment includes the second display unit 20 and the luminance measurement unit 9 to measure the luminance of the second display unit 20, aside from the first display unit 10 used as a display screen. The second display unit 20 is lit and the luminance decrease rate is measured on a real time. It thereby becomes possible to obtain the luminance decrease rate corresponding to the accumulated lighting time of each LED element in the first display unit with high accuracy, with reference to the luminance decrease rate of the measurement LED element in the second display unit 20, without measuring the luminance of the first display unit. Furthermore, since the luminance correction is performed by using the luminance decrease rate, it is possible to perform the luminance correction with significantly high accuracy. Therefore, even in a case where the LED display device 100 operates for a long time, it is possible to keep the luminance and the white balance in the entire screen of the first display unit 10.

Further, in the LED display device 100 of the first preferred embodiment, the accumulated lighting time estimation unit 6 calculates a first accumulated lighting time up to a time traced back by the predetermined time from the present time for each of the plurality of LED elements, by multiplying an accumulated operating time of the LED display device 100 up to the time traced back by the predetermined time from the present time by an average duty ratio of the LED element, the accumulated lighting time estimation unit 6 calculates a second accumulated lighting time from the predetermined time ago up to the present time for each of the plurality of LED elements, by multiplying an accumulated operating time of the LED display device 100 from the predetermined time ago up to the present time by a duty ratio of the LED element at the present time, the accumulated lighting time estimation unit 6 calculates an accumulated lighting time up to the present time for each of the plurality of LED elements, by adding the first accumulated lighting time and the second accumulated lighting time, the accumulated lighting time estimation unit 6 updates the average duty ratio for each of the plurality of LED elements by a value obtained by dividing the accumulated lighting time up to the present time by the accumulated operating time of the LED display device 100 up to the present time and stores the average duty ratio into the average duty ratio storage unit 7, and the accumulated lighting time estimation unit 6 performs calculation of the accumulated lighting time up to the present time and update of the average duty ratio at intervals of the predetermined time for each of the plurality of LED elements.

In the first preferred embodiment, the actual duty ratio with which each LED element is driven is acquired at intervals of the accumulated operating unit time (i.e., the predetermined time) and the accumulated lighting time is estimated on the assumption that the LED element is driven with this duty ratio for the accumulated operating unit time. Therefore, in a case where there is less time variation of the image displayed on the first display unit 10, it is possible to estimate the accumulated lighting time particularly with high accuracy. Further, since the average duty ratio is obtained by dividing the estimated accumulated lighting time by the accumulated operating time and this average duty ratio is used for next calculation of the accumulated lighting time, it is possible to calculate the accumulated lighting time with high accuracy.

Furthermore, in the LED display device 100 of the first preferred embodiment, the luminance correction coefficient calculation unit 12 calculates the luminance correction coefficient for each of all the LED elements with a luminance decrease rate of one of the LED elements, which has the largest luminance decrease rate, used as a reference.

In the first preferred embodiment, the luminances of all the LED elements are made equal to one another in accordance with the luminance decrease rate of one of the LED elements included in the first display unit 10, which has the largest luminance decrease rate. It is thereby possible to keep the luminance and the white balance uniform in the entire display screen.

Further, in the LED display device 100 of the first preferred embodiment, the second driving unit 8 drives the measurement LED element with a duty ratio of 100 % during a period while the LED display device 100 operates.

By always driving the measurement LED element with the duty ratio of 100 %, the measurement LED element is being lit for a longer time than any one of the LED elements included in the first display unit 10. Therefore, it becomes possible to obtain the luminance decrease rate of each of the LED elements included in the first display unit 10 with reference to the luminance decrease rate of the measurement LED element.

Furthermore, the luminance correction method of the first preferred embodiment is a luminance correction method for the LED display device 100, and the LED display device 100 includes the first display unit 10 which includes a plurality of LED elements, the first driving unit 5 to drive the first display unit 10 on the basis of a video signal received from the video signal processing unit 3, the second display unit 20 which includes at least one measurement LED element equivalent to one of the plurality of LED elements included in the first display unit 10, the second driving unit 8 to drive the second display unit 20, the luminance measurement unit 9, the luminance decrease rate storage unit 11, the accumulated lighting time estimation unit 6, the average duty ratio storage unit 7, the luminance correction coefficient calculation unit 12, and the luminance correction unit 4, and the luminance correction method includes the steps of (a) measuring a luminance of the measurement LED element by the luminance measurement unit 9, (b) storing a relation between a lighting time of the measurement LED element and a luminance decrease rate of the measurement LED element based on a measurement result of the luminance measurement unit 9 into the luminance decrease rate storage unit 11, (c) estimating an accumulated lighting time at intervals of a predetermined time for each of the plurality of LED elements by the accumulated lighting time estimation unit 6, (d) storing an average duty ratio obtained by dividing the accumulated lighting time which is estimated, by an accumulated operating time for the plurality of LED elements in the average duty ratio storage unit 7, (e) obtaining a luminance decrease rate with reference to the luminance decrease rate storage unit 11 and the average duty ratio storage unit 7 for each of the plurality of LED elements and calculating a luminance correction coefficient from the luminance decrease rate by the luminance correction coefficient calculation unit 12, and (f) controlling the first driving unit 5 to correct a luminance of each of the plurality of LED elements on the basis of the luminance correction coefficient by the luminance correction unit 4.

In the first preferred embodiment, in the above-described step (c), the accumulated lighting time is estimated at intervals of the accumulated operating unit time (i.e., the predetermined time) sufficiently longer than the PMW cycle. Therefore, it is possible to significantly suppress the throughput required for the computation, as compared with the case where the accumulated lighting time is calculated for every PMW cycle. Further, since the accumulated lighting time is not calculated for every PMW cycle, it becomes possible to significantly reduce the amount of computation and the number of storing operations of data into the nonvolatile memory. Therefore, it is possible to reduce the power consumption due to these signal processings.

Further, in the first preferred embodiment, in the above-described step (d), the average duty ratio storage unit 7 stores therein the average duty ratio calculated on the basis of the accumulated lighting time, instead of the accumulated lighting time. Since the accumulated lighting time increases as the operating time of the LED display device 100 becomes longer, the amount of data for the accumulated lighting time also increases. On the other hand, since the amount of data for the average duty ratio does not increase, it is possible reduce the amount of data to be stored in the average duty ratio storage unit 7.

Further, the LED display device 100 of the first preferred embodiment includes the second display unit 20 and the luminance measurement unit 9 to measure the luminance of the second display unit 20, aside from the first display unit 10 used as a display screen. The second display unit 20 is lit and the luminance decrease rate is measured on a real time. It thereby becomes possible to obtain the luminance decrease rate corresponding to the accumulated lighting time of each LED element in the first display unit with high accuracy, with reference to the luminance decrease rate of the measurement LED element in the second display unit 20, without measuring the luminance of the first display unit. Furthermore, since the luminance correction is performed by using the luminance decrease rate, it is possible to perform the luminance correction with significantly high accuracy. Therefore, even in a case where the LED display device 100 operates for a long time, it is possible to keep the luminance and the white balance in the entire screen of the first display unit 10.

Furthermore, in the luminance correction method of the first preferred embodiment, the step (c) includes the steps of (c1) calculating a first accumulated lighting time up to a time traced back by the predetermined time from the present time for each of the plurality of LED elements, by multiplying an accumulated operating time of the LED display device 100 up to the time traced back by the predetermined time from the present time by an average duty ratio of the LED element by the accumulated lighting time estimation unit 6, (c2) calculating a second accumulated lighting time from the predetermined time ago up to the present time for each of the plurality of LED elements, by multiplying an accumulated operating time of the LED display device 100 from the predetermined time ago up to the present time by a duty ratio of the LED element at the present time by the accumulated lighting time estimation unit 6, (c3) calculating an accumulated lighting time up to the present time for each of the plurality of LED elements, by adding the first accumulated lighting time and the second accumulated lighting time by the accumulated lighting time estimation unit 6 after the steps (c1) and (c2), and (c4) updating the average duty ratio for each of the plurality of LED elements by a value obtained by dividing the accumulated lighting time up to the present time by the accumulated operating time of the LED display device 100 up to the present time and storing the average duty ratio into the average duty ratio storage unit 7 by the accumulated lighting time estimation unit 6 after the step (c3), and the accumulated lighting time estimation unit 6 repeats the steps (c1), (c2), (c3), and (c4) at intervals of the predetermined time.

In the first preferred embodiment, the actual duty ratio with which each LED element is driven is acquired at intervals of the accumulated operating unit time (i.e., the predetermined time) and the accumulated lighting time is estimated on the assumption that the LED element is driven with this duty ratio for the accumulated operating unit time. Therefore, in a case where there is less time variation of the image displayed on the first display unit 10, it is possible to estimate the accumulated lighting time particularly with high accuracy. Further, since the average duty ratio is obtained by dividing the estimated accumulated lighting time by the accumulated operating time and this average duty ratio is used for next calculation of the accumulated lighting time, it is possible to calculate the accumulated lighting time with high accuracy.

Furthermore, in the step (e) of the luminance correction method of the first preferred embodiment, the luminance correction coefficient calculation unit 12 calculates the luminance correction coefficient for each of all the LED elements with a luminance decrease rate of one of the LED elements, which has the largest luminance decrease rate, used as a reference.

In the first preferred embodiment, in the step (e), the luminances of all the LED elements are made equal to one another in accordance with the luminance decrease rate of one of the LED elements included in the first display unit 10, which has the largest luminance decrease rate. It is thereby possible to keep the luminance and the white balance uniform in the entire display screen.

Further, in the luminance correction method of the first preferred embodiment, the second driving unit 8 drives the measurement LED element with a duty ratio of 100 % during a period while the LED display device 100 operates.

By always driving the measurement LED element with the duty ratio of 100 %, the measurement LED element is being lit for a longer time than any one of the LED elements included in the first display unit 10. Therefore, it becomes possible to obtain the luminance decrease rate of each of the LED elements included in the first display unit 10 with reference to the luminance decrease rate of the measurement LED element.

<The Second Preferred Embodiment

In the first preferred embodiment, the second accumulated lighting time $S_1$ is calculated on the assumption that the LED element is driven with the duty ratio of $R_1$ at the present time for the unit operating time (see Eq. 2).

In the second preferred embodiment, in order to calculate the second accumulated lighting time $S_1$ with higher accuracy, the second accumulated lighting time $S_1$ is calculated by using a duty ratio obtained by an addition average of the average duty ratio $R_0$ stored in the average duty ratio storage unit 7 and the duty ratio $R_1$ at the present time. Further, since an LED display device 100 of the second preferred embodiment has the same constitution of that in the first preferred embodiment (see Figs. 1 and 2), description thereof will be omitted. In the second preferred embodiment, the second accumulated lighting time $S_1$ can be expressed by the following Eq. 9.

[Math 9]

$$S_1 = S_0 + \frac{(R_0 + R_1)}{2} \times t_1 \qquad \cdots (9)$$

In the second preferred embodiment, a method of calculating the first accumulated lighting time is the same as that in the first preferred embodiment (see Eq. 1). Therefore, the average duty ratio $R_2$ at the present time in the second preferred embodiment can be expressed by the following Eq. 10.

[Math 10]

$$R_2 = \frac{S_1}{t_0 + t_1} = \frac{2 \times R_0 \times t_0 + (R_0 + R_1) \times t_1}{2(t_0 + t_1)} \qquad \cdots (10)$$

The accumulated lighting time estimation unit 6 obtains the average duty ratio $R_2$ for each of the LED elements at intervals of a certain time (i.e., the accumulated operating unit time) from the time when the operating time of the LED display device 100 is zero, i.e., $t_0 = 0$, and thereby updates the average duty ratio stored in the average duty ratio storage unit 7, like in the first preferred embodiment.

<Effects>

In the LED display device 100 of the second preferred embodiment, the accumulated lighting time estimation unit 6 calculates a first accumulated lighting time up to a time traced back by the predetermined time from the present time for each of the plurality of LED elements, by multiplying an accumulated operating time of the LED display device 100 up to the time traced back by the predetermined time from the present time by an average duty ratio of the LED element, the accumulated lighting time estimator 6 calculates a second accumulated lighting time from the predetermined time ago up to the present time for each of the plurality of LED elements, by multiplying an accumulated operating time of the LED display device 100 from the predetermined time ago up to the present time by an addition average of a duty ratio at the present time and the average duty ratio of the LED element, the accumulated lighting time estimation unit 6 calculates an accumulated lighting time up to the present time for each of the plurality of LED elements, by adding the first accumulated lighting time and the second accumulated lighting time, the accumulated lighting time estimation unit 6 updates the average duty ratio for each of the plurality of LED elements by a value obtained by dividing the accumulated lighting time up to the present time by the accumulated operating time of the LED display device up to the present time and stores the average duty ratio into the average duty ratio storage unit 7, and the accumulated lighting time estimation unit 6 performs calculation of the accumulated lighting time up to the present time and update of the average duty ratio at intervals of the predetermined time for each of the plurality of LED elements.

In the second preferred embodiment, the second accumulated lighting time is calculated by using the addition average of the duty ratio at the present time and the average duty ratio of the LED element. Therefore, it is possible to reduce an error from the actual accumulated lighting time, as compared with the first preferred embodiment in which the second accumulated lighting time is calculated by using the duty ratio at the present time of the LED element.

Further, in the luminance correction method of the second preferred embodiment, the step (c) (i.e., the step of estimating the accumulated lighting time at intervals of the predetermined time for each of the plurality of LED elements by the accumulated lighting time estimation unit 6) includes the steps of (c1) calculating a first accumulated lighting time up to a time traced back by the predetermined time from the present time for each of the plurality of LED elements, by multiplying an accumulated operating time of the LED display device 100 up to the time traced back by the predetermined time from the present time by an average duty ratio of the LED element by the accumulated lighting time estimation unit 6, (c2) calculating a second accumulated lighting time from the predetermined time ago up to the present time for each of the plurality of LED elements, by multiplying an accumulated operating time of the LED display device 100 from the predetermined time ago up to the present time by an addition average of a duty ratio at the present time and the average duty ratio of the LED element by the accumulated lighting time estimation unit 6, (c3) calculating an accumulated lighting time up to the present time for each of the plurality of LED elements, by adding the first accumulated lighting time and the second accumulated lighting time by the accumulated lighting time estimator (6) after the steps (c1) and (c2), and (c4) updating the average duty ratio for each of the plurality of LED elements by a value obtained by dividing the accumulated lighting time up to the present time by the accumulated operating time of the LED display device 100 up to the present time and storing the average duty ratio into the average duty ratio storage unit 7 by the accumulated lighting time estimation unit 6 after the step (c3), and the accumulated lighting time estimation unit 6 repeats the steps (c1), (c2), (c3), and (c4) at intervals of the predetermined time.

In the second preferred embodiment, in the above-described step (c2), the second accumulated lighting time is calculated by using the addition average of the duty ratio at the present time and the average duty ratio of the LED element. Therefore, it is possible to reduce an error from the actual accumulated lighting time, as compared with the first preferred embodiment in which the second accumulated lighting time is calculated by using the duty ratio at the present time of the LED element.

Further, though the second display unit 20 includes a plurality of (four) unit pixels in the first and second preferred embodiments, the second display unit 20 does not necessarily need to include a plurality of unit pixels. The second display unit 20 may include, for example, one unit pixel.

Furthermore, though the first display unit 10 includes a plurality of unit pixels and the unit pixel includes three LED elements for red, green, and blue in the first and second preferred embodiments, the unit pixel may include, for example, one LED element or a plurality of LED elements for single color (for example, red). In this case, the second display unit 20 includes at least one measurement LED element.

Further, though the calculation of the accumulated lighting time and the update of the average duty ratio are performed at a time for all the LED elements in a unit of certain time in the first and second preferred embodiment, the processings for all the LED elements do not necessarily need to be performed at a time. The processings for all the LED elements may be performed in a certain time period, and for example, the processings for each LED element may be performed in sequence in a unit of frame. In a case where the processings for all the LED elements are performed at a time, the load on the accumulated lighting time estimation unit 6 and the average duty ratio storage unit 7 temporarily increases. On the other hand, in another case where the processings for each LED element are performed in sequence, the above-described load can be averaged in time.

While the invention has been shown and described in detail, the foregoing description is in all aspects illustrative and not restrictive. It is therefore understood that numerous modifications and variations can be devised without departing from the scope of the invention.

Explanation of Reference Signs

2 input terminal, 3 video signal processing unit, 4 luminance correction unit, 5 first driving unit, 6 accumulated lighting time estimation unit, 7 average duty ratio storage unit, 8 second driving unit, 9 luminance measurement unit, 10 first display unit, 11 luminance decrease rate storage unit, 12 luminance correction coefficient calculation unit, 20 second display unit, 31 input interface, 32 processing circuit, 33 first driving circuit, 34 first display device, 35 storage device, 36 memory, 37 luminance measurement device, 38 second driving circuit, 39 second display device, 40 bus, 100 LED display device

**Claims**

1. An LED display device (100), comprising:

   a first display (10) which comprises a plurality of LED elements;
   a first driver (5) to drive said plurality of LED elements of said first display (10) on the basis of a video signal received from a video signal processor (3);
   a second display (20) which comprises at least one measurement LED element equivalent to one of said plurality of LED elements included in said first display (10);
   a second driver (8) to drive said measurement LED element of said second display (20);
   a luminance measurer (9) to measure a luminance of said measurement LED element;
   a luminance decrease rate storage (11) to store therein a relation between a lighting time of said measurement LED element and a luminance decrease rate of said measurement LED element based on a measurement result of said luminance measurer (9);
   an accumulated lighting time estimator (6) to estimate an accumulated lighting time at intervals of a predetermined time for each of said plurality of LED elements;
   an average duty ratio storage (7) to store therein an average duty ratio obtained by dividing said accumulated lighting time which is estimated, by an accumulated operating time for said plurality of LED elements;
   a luminance correction coefficient calculator (12) to obtain a luminance decrease rate with reference to said luminance decrease rate storage (11) and said average duty ratio storage (7) for each of said plurality of LED elements and calculate a luminance correction coefficient from said luminance decrease rate; and
   a luminance corrector (4) to control said first driver to correct a luminance of each of said plurality of LED elements on the basis of said luminance correction coefficient.

2. The LED display device (100) according to claim 1, wherein
   said accumulated lighting time estimator (6) calculates a first accumulated lighting time up to a time traced back by said predetermined time from the present time for each of said plurality of LED elements, by multiplying an accumulated operating time of said LED display device (100) up to said time traced back by said predetermined time from said present time by an average duty ratio of the LED element,
   said accumulated lighting time estimator (6) calculates a second accumulated lighting time from said predetermined time ago up to said present time for each of said plurality of LED elements, by multiplying an accumulated operating time of said LED display device from said predetermined time ago up to said present time by a duty ratio of the LED element at said present time,
   said accumulated lighting time estimator (6) calculates an accumulated lighting time up to said present time for each of said plurality of LED elements, by adding said first accumulated lighting time and said second accumulated lighting time,

said accumulated lighting time estimator (6) updates said average duty ratio for each of said plurality of LED elements by a value obtained by dividing said accumulated lighting time up to said present time by said accumulated operating time of said LED display device up to said present time and stores said average duty ratio into said average duty ratio storage (7), and

said accumulated lighting time estimator (6) performs calculation of said accumulated lighting time up to said present time and update of said average duty ratio at intervals of said predetermined time for each of said plurality of LED elements.

3. The LED display device (100) according to claim 1, wherein

said accumulated lighting time estimator (6) calculates a first accumulated lighting time up to a time traced back by said predetermined time from the present time for each of said plurality of LED elements, by multiplying an accumulated operating time of said LED display device (100) up to said time traced back by said predetermined time from said present time by an average duty ratio of the LED element,

said accumulated lighting time estimator (6) calculates a second accumulated lighting time from said predetermined time ago up to said present time for each of said plurality of LED elements, by multiplying an accumulated operating time of said LED display device from said predetermined time ago up to said present time by an addition average of a duty ratio at said present time and said average duty ratio of the LED element,

said accumulated lighting time estimator (6) calculates an accumulated lighting time up to said present time for each of said plurality of LED elements, by adding said first accumulated lighting time and said second accumulated lighting time,

said accumulated lighting time estimator updates said average duty ratio for each of said plurality of LED elements by a value obtained by dividing said accumulated lighting time up to said present time by said accumulated operating time of said LED display device up to said present time and stores said average duty ratio into said average duty ratio storage (7), and

said accumulated lighting time estimator (6) performs calculation of said accumulated lighting time up to said present time and update of said average duty ratio at intervals of said predetermined time for each of said plurality of LED elements.

4. The LED display device (100) according to any one of claims 1 to 3, wherein

said luminance correction coefficient calculator (12) calculates a luminance correction coefficient for each of all said plurality of LED elements with a luminance decrease rate of one of said plurality of LED elements, which has the largest luminance decrease rate, used as a reference.

5. The LED display device (100) according to any one of claims 1 to 4, wherein

said second driver (8) drives said measurement LED element with a duty ratio of 100 % during a period while said LED display device operates.

6. A luminance correction method for an LED display device (100), wherein

said LED display device (100) comprises:

a first display (10) which comprises a plurality of LED elements;
a first driver (5) to drive said first display (10) on the basis of a video signal received from a video signal processor (3);
a second display (20) which comprises at least one measurement LED element equivalent to one of said plurality of LED elements included in said first display (10);
a second driver (8) to drive said second display (20);
a luminance measurer (9);
a luminance decrease rate storage (11);
an accumulated lighting time estimator (6);
an average duty ratio storage (7);
a luminance correction coefficient calculator (12); and
a luminance corrector (4),

said luminance correction method comprising:

(a) measuring a luminance of said measurement LED element by said luminance measurer (9);
(b) storing a relation between a lighting time of said measurement LED element and a luminance decrease rate of said measurement LED element based on a measurement result of said luminance measurer (9) into said luminance decrease rate storage (11);

(c) estimating an accumulated lighting time at intervals of a predetermined time for each of said plurality of LED elements by said accumulated lighting time estimator (6);

(d) storing an average duty ratio obtained by dividing said accumulated lighting time which is estimated, by an accumulated operating time for said plurality of LED elements into said average duty ratio storage (7);

(e) obtaining a luminance decrease rate with reference to said luminance decrease rate storage (11) and said average duty ratio storage (7) for each of said plurality of LED elements and calculating a luminance correction coefficient from said luminance decrease rate by said luminance correction coefficient calculator; and

(f) controlling said first driver (5) to correct a luminance of each of said plurality of LED elements on the basis of said luminance correction coefficient by said luminance corrector (4).

**7.** The luminance correction method according to claim 6, wherein
said operation (c) comprises:

(c1) calculating a first accumulated lighting time up to a time traced back by said predetermined time from the present time for each of said plurality of LED elements, by multiplying an accumulated operating time of said LED display device up to said time traced back by said predetermined time from said present time by an average duty ratio of the LED element by said accumulated lighting time estimator (6);

(c2) calculating a second accumulated lighting time from said predetermined time ago up to said present time for each of said plurality of LED elements, by multiplying an accumulated operating time of said LED display device from said predetermined time ago up to said present time by a duty ratio of the LED element at said present time by said accumulated lighting time estimator (6);

(c3) calculating an accumulated lighting time up to said present time for each of said plurality of LED elements, by adding said first accumulated lighting time and said second accumulated lighting time by said accumulated lighting time estimator (6) after said operations (c1) and (c2); and

(c4) updating said average duty ratio for each of said plurality of LED elements by a value obtained by dividing said accumulated lighting time up to said present time by said accumulated operating time of said LED display device up to said present time and storing said average duty ratio into said average duty ratio storage (7) by said accumulated lighting time estimator (6) after said operation (c3), and

said accumulated lighting time estimator (6) repeats said operations (c1), (c2), (c3), and (c4) at intervals of said predetermined time.

**8.** The luminance correction method according to claim 6, wherein
said operation (c) comprises:

(c1) calculating a first accumulated lighting time up to a time traced back by said predetermined time from the present time for each of said plurality of LED elements, by multiplying an accumulated operating time of said LED display device up to said time traced back by said predetermined time from said present time by an average duty ratio of the LED element by said accumulated lighting time estimator (6);

(c2) calculating a second accumulated lighting time from said predetermined time ago up to said present time for each of said plurality of LED elements, by multiplying an accumulated operating time of said LED display device from said predetermined time ago up to said present time by an addition average of a duty ratio at said present time and said average duty ratio of the LED element by said accumulated lighting time estimator (6);

(c3) calculating an accumulated lighting time up to said present time for each of said plurality of LED elements, by adding said first accumulated lighting time and said second accumulated lighting time by said accumulated lighting time estimator (6) after said operations (c1) and (c2); and

(c4) updating said average duty ratio for each of said plurality of LED elements by a value obtained by dividing said accumulated lighting time up to said present time by said accumulated operating time of said LED display device up to said present time and storing said average duty ratio into said average duty ratio storage by said accumulated lighting time estimator (6) after said operation (c3), and

said accumulated lighting time estimator (6) repeats said operations (c1), (c2), (c3), and (c4) at intervals of said predetermined time.

**9.** The luminance correction method according to any one of claims 6 to 8, wherein

said luminance correction coefficient calculator calculates a luminance correction coefficient for each of all said plurality of LED elements with a luminance decrease rate of one of said plurality of LED elements, which has the largest luminance decrease rate, used as a reference in said operation (e).

10. The luminance correction method according to any one of claims 6 to 9, wherein
said second driver (8) drives said measurement LED element with a duty ratio of 100 % during a period while said LED display device operates.

# F I G . 1

# F I G . 2

F I G . 3

(a)

|←——————————— 1 FRAME ———————————→|

PMW BASIC CYCLE

(b)

DUTY RATIO:85%

(c)

DUTY RATIO:80%

F I G . 4

START

CALCULATE FIRST ACCUMULATED LIGHTING TIME —S101

CALCULATE SECOND ACCUMULATED LIGHTING TIME —S102

CALCULATE ACCUMULATED LIGHTING TIME UP TO PRESENT TIME —S103

CALCULATE AVERAGE DUTY RATIO —S104

UPDATE AVERAGE DUTY RATIO —S105

F I G . 5

F I G . 6

F I G . 7

```
                        ┌─────────┐
                        │  START  │
                        └────┬────┘
                             │        ┌──S201
                             ▼
              ╱──────────────────────────────╲    NO
             ╱   HAS LUMINANCE CORRECTION      ╲───────┐
             ╲     UNIT TIME ELAPSED?          ╱        │
              ╲──────────────┬───────────────╱         │
                             │ YES    ┌──S202           │
                             ▼                          │
          ┌──────────────────────────────────┐         │
          │  CALCULATE MAXIMUM ACCUMULATED    │         │
          │  LIGHTING TIME OF LED ELEMENT     │         │
          │         FOR EACH COLOR            │         │
          └─────────────────┬────────────────┘         │
                            │        ┌──S203            │
                            ▼                           │
          ┌──────────────────────────────────┐         │
          │  OBTAIN LUMINANCE DECREASE RATE   │         │
          │   CORRESPONDING TO MAXIMUM        │         │
          │   ACCUMULATED LIGHTING TIME       │         │
          └─────────────────┬────────────────┘         │
                            │        ┌──S204            │
                            ▼                           │
          ┌──────────────────────────────────┐         │
          │   DETERMINE MAXIMUM LUMINANCE     │         │
          │         DECREASE RATE             │         │
          └─────────────────┬────────────────┘         │
                            │        ┌──S205            │
                            ▼                           │
          ┌──────────────────────────────────┐         │
          │  CALCULATE LUMINANCE CORRECTION   │         │
          │  COEFFICIENT OF EACH LED ELEMENT  │         │
          └─────────────────┬────────────────┘         │
                            │        ┌──S206            │
                            ▼                           │
          ┌──────────────────────────────────┐         │
          │   PERFORM LUMINANCE CORRECTION    │         │
          │      OF EACH LED ELEMENT          │         │
          └─────────────────┬────────────────┘         │
                            │                           │
                            ▼                           │
                        ┌─────────┐                     │
                        │   END   │                     │
                        └─────────┘                     │
```

## INTERNATIONAL SEARCH REPORT

| International application No. |
| --- |
| PCT/JP2016/073131 |

**A. CLASSIFICATION OF SUBJECT MATTER**
*G09G3/32*(2016.01)i, *G09G3/20*(2006.01)i, *G09G3/34*(2006.01)i, *H01L33/00*(2010.01)i, *H05B37/02*(2006.01)i

According to International Patent Classification (IPC) or to both national classification and IPC

**B. FIELDS SEARCHED**

Minimum documentation searched (classification system followed by classification symbols)
G09G3/32, G09G3/20, G09G3/34, H01L33/00, H05B37/02

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2007-72056 A  (Seiko Epson Corp.),<br>22 March 2007 (22.03.2007),<br>paragraphs [0016] to [0036]; fig. 1 to 3<br>(Family: none) | 1,4-6,9-10<br>2-3,7-8 |
| Y<br>A | JP 2011-82213 A  (Sony Corp.),<br>21 April 2011 (21.04.2011),<br>paragraphs [0027] to [0047]; fig. 1 to 10<br>(Family: none) | 1,4-6,9-10<br>2-3,7-8 |
| Y | JP 2013-54260 A  (Canon Inc.),<br>21 March 2013 (21.03.2013),<br>paragraphs [0031] to [0035]; fig. 1 to 3<br>& US 2013/0057570 A1<br>paragraphs [0043] to [0048]; fig. 1 to 3<br>& CN 102982763 A | 1,4-6,9-10 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>   11 October 2016 (11.10.16) | Date of mailing of the international search report<br>   18 October 2016 (18.10.16) |
| --- | --- |
| Name and mailing address of the ISA/<br>   Japan Patent Office<br>   3-4-3,Kasumigaseki,Chiyoda-ku,<br>   Tokyo 100-8915,Japan | Authorized officer<br><br>Telephone No. |

Form PCT/ISA/210 (second sheet) (January 2015)

22

**INTERNATIONAL SEARCH REPORT**

International application No.

PCT/JP2016/073131

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2008-76741 A  (Sony Corp.),<br>03 April 2008 (03.04.2008),<br>entire text<br>(Family: none) | 1-10 |
| A | JP 2012-128147 A  (Sony Corp.),<br>05 July 2012 (05.07.2012),<br>entire text<br>& US 2012/0154682 A1     & CN 102542970 A | 1-10 |

Form PCT/ISA/210 (continuation of second sheet) (January 2015)

**EP 3 343 550 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11015437 A

- JP 2006330158 A